# EUROPEAN PATENT APPLICATION

(11) **EP 4 575 717 A1**
(43) Date of publication of application: **25.06.2025**
(21) Application number: 23909104.4
(22) Date of filing: 06.07.2023
(51) Int. Cl.: G06F 1/20

(54) **ELECTRONIC APPARATUSES**

(30) Priority: 30.12.2022 US 202263436203 P
(71) Applicant: Delta Electronics, Inc., Taoyuan City 33370 (TW)
(72) Inventor: SHEN, Yu-Chieh, Taoyuan City, Taiwan 33370 (TW); SU, Chen-Chiang, Taoyuan City, Taiwan 33370 (TW); LO, Yung-Chun, Taoyuan City, Taiwan 33370 (TW)
(74) Representative: Uexküll & Stolberg
(86) International application number: PCT/CN2023/106136
(87) International publication number: WO 2024/139160

(57) **Abstract**

An electronic device is provided. The electronic device is disposed in a cooling liquid of a cooling slot. The electronic device includes a carrier portion, an electronic component, a thermal source region and a filling component. The carrier portion includes a plurality of side walls and a carrier main body. The plurality of side walls are disposed around the carrier main body to form a first accommodation space and a second accommodation space. The electronic component includes a thermal source disposed in the second accommodation space of the carrier portion. The thermal source region is disposed in the carrier portion and corresponding in position to the thermal source. The filling component is disposed in the first accommodation space for limiting or avoiding the cooling liquid from immersing into the first accommodation space. The filling component is configured to limit or guide the cooling liquid from passing through the thermal source region, and the cooling liquid is configured to exchange a thermal with the thermal source region.

## Description

### FIELD OF THE INVENTION

The present invention relates to an electronic device and more particularly to an electronic device with reduced cost.

### BACKGROUND OF THE INVENTION

In general, the electronic device includes a fan for dissipating the thermal of electronic component disposed within the electronic device. In the practical application, when the electronic device is disposed within the cooling slot for dissipating the thermal by the cooling liquid, the fan is omitted in the electronic device for increasing the space. Consequently, a great volume of cooling liquid is immersed to the cooling slot to fill the space of the electronic device. The cost of the cooling liquid is increased.

Therefore, there is a need of providing an electronic device to obviate the drawbacks encountered from the prior arts.

### SUMMARY OF THE INVENTION

The present disclosure provides an electronic device. The electronic device includes a filling component. The filling component covers the electronic component and the carrier portion, or disposed between the electronic components of the electronic device, or disposed between the electronic component and the mechanical component, or disposed in the space between the mechanical components. Consequently, when the electronic device is disposed in the cooling slot, the filling component fills in the space within the electronic device. The volume and the cost of the cooling liquid are reduced.

Moreover, the electronic device of the present disclosure includes a liquid channel. The flow direction or the flow speed of the cooling liquid are limited through the liquid channel. The convection capability of the cooling liquid passing through the liquid channel is enhanced. Consequently, the dissipation capability of the cooling liquid for the thermal source region is enhanced.

Moreover, the electronic device of the present disclosure includes an accommodation space for receiving the filling component. The volume and the cost of the cooling liquid passing through the accommodation space are reduced.

In accordance with an aspect of the present disclosure, there is provided an electronic device. The electronic device is disposed in a cooling liquid of a cooling slot. The electronic device includes a carrier portion, an electronic component, a thermal source region and a filling component. The electronic component is disposed on the carrier portion and includes a thermal source. The thermal source region is disposed in the carrier portion and corresponding in position to the thermal source. The filling component is disposed on the electronic component and includes at least one liquid channel. The at least one liquid channel runs through the filling component. The at least one liquid channel is communicated with the thermal source region for limiting or guiding the cooling liquid from passing through the thermal source region. The cooling liquid is configured to exchange a thermal with the thermal source region.

In accordance with another aspect of the present disclosure, there is provided an electronic device. The electronic device is disposed in a cooling liquid of a cooling slot. The electronic device includes a carrier portion, an electronic component, a thermal source region and a filling component. The carrier portion includes a first accommodation space. The first accommodation space is formed within the carrier portion. The electronic component is disposed on the carrier portion and includes a thermal source. The thermal source region is disposed in the carrier portion and corresponding in position to the thermal source. The filling component is a sealed structure and fills in the first accommodation space for limiting or avoiding the cooling liquid from immersing into the first accommodation space. The filling component is configured to limit or guide the cooling liquid from passing through the thermal source region. The cooling liquid is configured to exchange a thermal with the thermal source region.

In accordance with another aspect of the present disclosure, there is provided an electronic device. The electronic device is disposed in a cooling liquid of a cooling slot. The electronic device includes a carrier portion, an electronic component, a thermal source region and a filling component. The carrier portion includes a plurality of side walls and a carrier main body. The plurality of side walls are disposed around the carrier main body to form a first accommodation space and a second accommodation space. The electronic component includes a thermal source disposed in the second accommodation space of the carrier portion. The thermal source region is disposed in the carrier portion and corresponding in position to the thermal source. The filling component is disposed in the first accommodation space for limiting or avoiding the cooling liquid from immersing into the first accommodation space. The filling component is configured to limit or guide the cooling liquid from passing through the thermal source region, and the cooling liquid is configured to exchange a thermal with the thermal source region.

### BRIEF DESCRIPTION OF THE DRAWINGS

FIG. 1 is a schematic view illustrating an electronic device according to a first embodiment of the present disclosure;
FIG. 2A is a schematic exploded view illustrating the electronic device as shown in FIG. 1;
FIG. 2B is a schematic exploded view illustrating the electronic device as shown in FIG. 1 taken along another viewpoint;
FIG. 3 is a schematic cross-sectional view illustrating the electronic device as shown in FIG. 1 taken along the line A-A';
FIG. 4 is a schematic view illustrating an electronic device according to a second embodiment of the present disclosure;
FIG. 5A is a schematic exploded view illustrating the electronic device as shown in FIG. 4;
FIG. 5B is a schematic exploded view illustrating the electronic device as shown in FIG. 4 taken along another viewpoint;
FIG. 6 is a schematic cross-sectional view illustrating the electronic device as shown in FIG. 4 taken along the line A-A';
FIG. 7 is a schematic view illustrating an electronic device according to a third embodiment of the present disclosure; and
FIG. 8 is a schematic exploded view illustrating the electronic device as shown in FIG. 7.

Description of reference numerals:
1, 1a, 1b: electronic device
2: carrier portion
21: carrier main body
22: front side wall
221: first through hole
23: first side wall
24: second side wall
25: rear side wall
251: second through hole
26: third side wall
27: third accommodation space
28: first accommodation space
29: second accommodation space
3: electronic component
31: thermal source
5: thermal source region
4: filling component
4a: first filling part
4b: second filling part
41: liquid channel
42: thermal dissipation portion
43: first flow hole
44: second flow hole
61: first separated space
62: second separated space

### DETAILED DESCRIPTION OF THE PREFERRED EMBODIMENT

The present disclosure will now be described more specifically with reference to the following embodiments. It is to be noted that the following descriptions of preferred embodiments of this invention are presented herein for purpose of illustration and description only. It is not intended to be exhaustive or to be limited to the precise form disclosed.

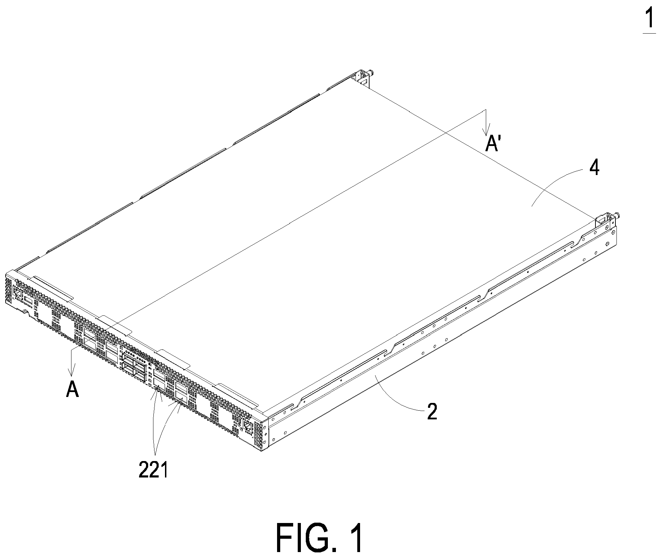

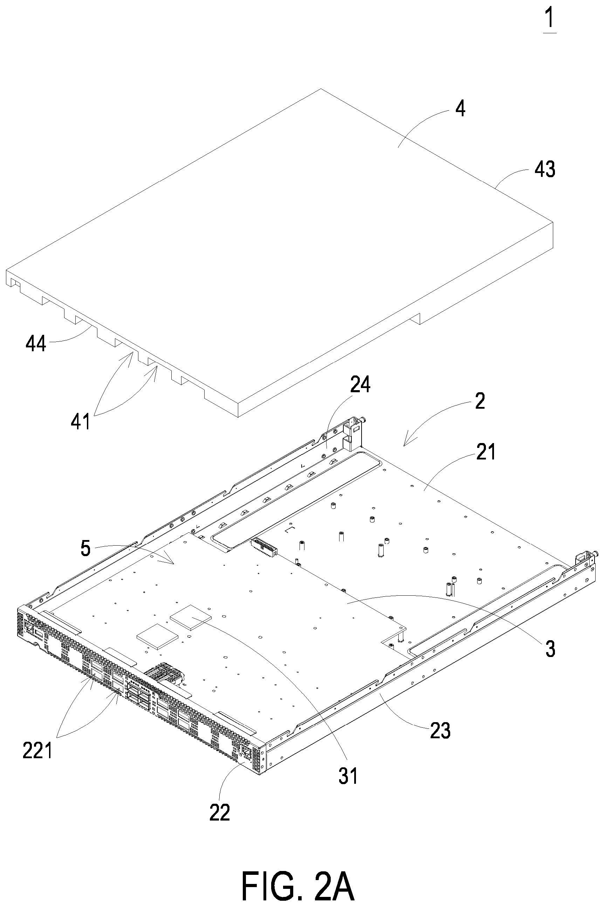

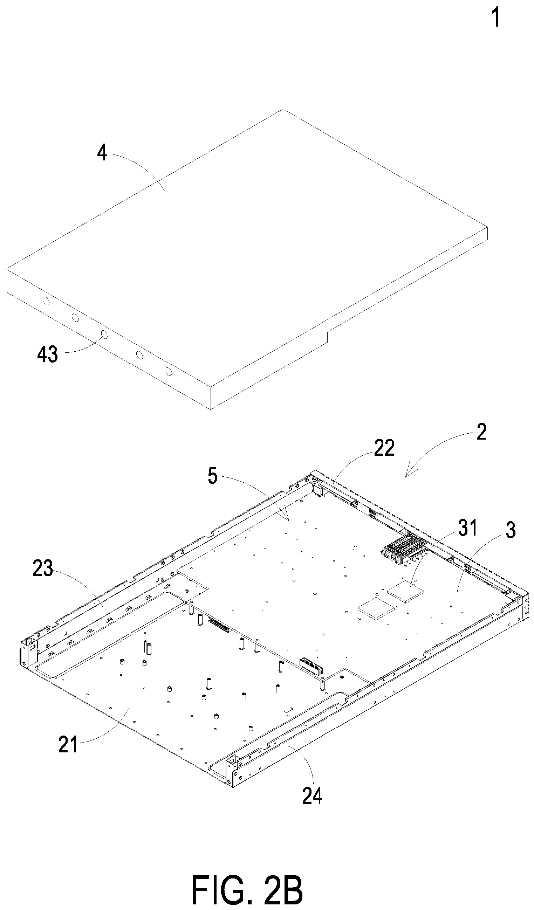

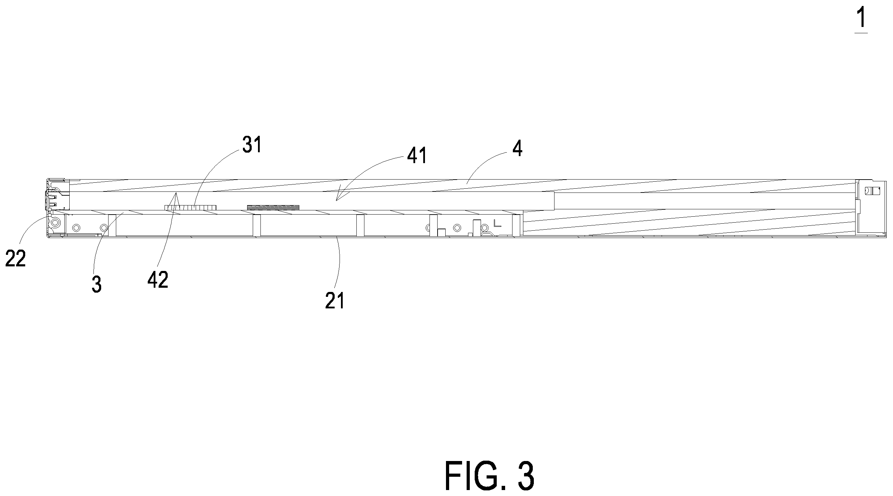

FIG. 1 is a schematic view illustrating an electronic device according to a first embodiment of the present disclosure. FIG. 2A is a schematic exploded view illustrating the electronic device as shown in FIG. 1. FIG. 2B is a schematic exploded view illustrating the electronic device as shown in FIG. 1 taken along another viewpoint. FIG. 3 is a schematic cross-sectional view illustrating the electronic device as shown in FIG. 1 taken along the line A-A'. The electronic device 1 of this embodiment is an industrial electronic device. For example, the electronic device 1 is CRPS/MCRPS power supply, industrial power supply, server power supply, server, or networking device. The electronic device 1 is disposed within a cooling liquid of a cooling slot (not shown) for dissipating the thermal of the electronic device 1. The electronic device 1 includes a carrier portion 2, an electronic component 3, a filling component 4 and a thermal source region 5.

The carrier portion 2 is an insulation structure for carrying the electronic component 3 and the filling component 4. The electronic device 3 is disposed on the carrier portion 2 and includes a thermal source 31. The thermal source 31 is central processing unit (CPU), dual in-line memory module (DIMM), PCIe card, graphics processing unit (GPU), electronic circuit, busbar, thermal sink, any thermal generating electronic component or thermal conductive structure. The thermal source region 5 is any region of the electronic device 1 requiring the cooling liquid for exchanging the thermal. For example, the thermal source region 5 is disposed on the carrier portion 2 and corresponding to nearby region of the thermal source 31 of the electronic component 3. The thermal source region 5 corresponding to the thermal source 31 dissipates the thermal through the cooling liquid.

The filling component 4 is a one-piece structure. The filling component 4 covers the electronic component 3 and the carrier portion 2. The electronic component 3 is disposed between the filling component 4 and the carrier portion 2. The filling component 4 includes at least one fluid channel 41, a thermal dissipation portion 42, a first flow hole 43 and a second flow hole 44. The liquid channel 41 passes through the two sides of the filling component 4. The liquid channel 41 and the thermal source region 5 are spatially corresponding in position to each other. For example, the thermal source region 5 is disposed within the corresponding liquid channel 41. Namely, the thermal source region 5 is completely contained in the liquid channel 41. In an embodiment, a portion structure of the liquid channel 41 forms the thermal dissipation portion 42. At least a portion of the thermal dissipation portion 42 and the thermal source region 5 of the electronic device 1 are spatially corresponding in position to each other. For example, at least a portion of the thermal dissipation portion 42 and the thermal source 31 are spatially corresponding in position to each other, as shown in FIG. 3. The first flow hole 43 and the second flow hole 44 are disposed on two opposite sides of the liquid channel 41. The cooling liquid passes through the liquid channel 41 through the first flow hole 43. The liquid channel 41 limits or guides the cooling liquid from passing through the thermal source region 5. The cooling liquid exchanges the thermal with the thermal source region 5. The cooling liquid flows out from the liquid channel 41 through the second flow hole 44. Consequently, the cooling liquid dissipates the thermal of the thermal source 31 of the thermal source region 5.

The space within the electronic device 1 of the present disclosure is filled through the volume of the filling component 4 for reducing the volume of the cooling liquid, so that the flow direction or the flow speed of the cooling liquid is limited. Consequently, the thermal dissipation capability of the cooling liquid to the thermal source 31 of the thermal source region 5 is enhanced. For example, the filling component 4 can be waterproof foam or other types of foam with low absorption or non-absorption properties. In some embodiments, the filling component 4 is plastic structure formed through processes such as plastic injection molding or blow molding. Preferably, the filling component 4 is a sealed plastic structure with a hollow portion. Alternatively, the filling component 4 can be a metal structure or other types of material capable of adapting to the cooling liquid. For example, the filling component 4 is waterproof foam, plastic structure, metal structure or any structure adapting to the cooling liquid. The filling component 4 occupies the space within the electronic device 1 so as to reduce the volume of the cooling liquid, and/or the residual space formed by the filling component 4 limits the flow direction or the flow speed of the cooling liquid. Consequently, the thermal dissipation capability of the cooling liquid to the thermal source 31 of the thermal source region 5 is enhanced.

From above, the electronic device 1 of the present disclosure includes a filling component 4. The filling component 4 covers the electronic component 3 and the carrier portion 2. When the electronic device 1 is disposed in the cooling slot, the space within the electronic device 1 is reduced so as to reduce the volume and the cost of the cooling liquid. Moreover, the filling component 4 of the electronic device 1 of the present disclosure includes a liquid channel 41 running through the two sides of the filling component 4. The liquid channel 41 limits or guides the cooling liquid passing through the thermal source region 5. The cooling liquid exchanges the thermal with the thermal source region 5. The convection capability of the cooling liquid passing through the liquid channel 41 is enhanced. Consequently, the cooling liquid dissipates the thermal of the thermal source 31 of the thermal source region 5.

Please refers to FIGS. 2A and 2B again. The carrier portion 2 includes a carrier main body 21 and a plurality of side walls. The plurality of side walls includes a front wall 22, a first side wall 23 and a second side wall 24. The first side wall 23, the front wall 22 and the second side wall 24 are disposed around and connected with the carrier main body 21. The first side wall 23 and the second side wall 24 are opposite to each other. The front side wall 22 is disposed between the first side wall 23 and the second side wall 24. The front side wall 22 includes a plurality of first through holes 221 arranged in sequence. The arrangement direction of the plurality of first through holes 221 is parallel to the direction from the first side wall 23 toward the second side wall 24. Each first through hole 221 runs through the front side wall 22. The first through hole 221 is at least partially communicated with the second flow hole 44 of the filling component 4. The electronic device 1 receives the cooling liquid through the first flow hole 43 of the filling component 4. The cooling liquid passes through the first flow hole 43, the liquid channel 41, the second flow hole 44 and the first through hole 221 of the front side wall 22 of the carrier portion 2 in sequence.

The electronic component 3 is disposed on the carrier main body 21 of the carrier portion 2, disposed between the first side wall 23 and the second side wall 24 of the carrier portion 2, and adjacent to the front side wall 22 of the carrier portion 2. As shown in FIGS. 2A and 2B, the front side wall 22, the first side wall 23, the second side wall 24 and the electronic component 3 defines the thermal source region 5 collaboratively. When the electronic device 1 dissipates the thermal through a fan (not shown), the fan is disposed in the thermal source region 5, so that the thermal is dissipated through airflow. When the electronic device 1 is disposed in the cooling liquid of the cooling slot and the fan is omitted, the thermal source region 5 is empty to form a space. The filling component 4 is disposed in the thermal source region 5 on the electronic component 3, disposed between the first side wall 23 and the second side wall 24 of the carrier portion 5, and adjacent to the front side wall 22 of the carrier portion 2. The electronic component 3 is disposed between the filling component 4 and the carrier main body 21 of the carrier portion 2. The electronic component 3 is covered by the carrier portion 2 and the filling component 4 collaboratively. In this embodiment, each liquid channel 41 runs through the filling component 4. The extension direction of each liquid channel 41 is parallel to the first side wall 23 and the second side wall 24 of the carrier portion 2.

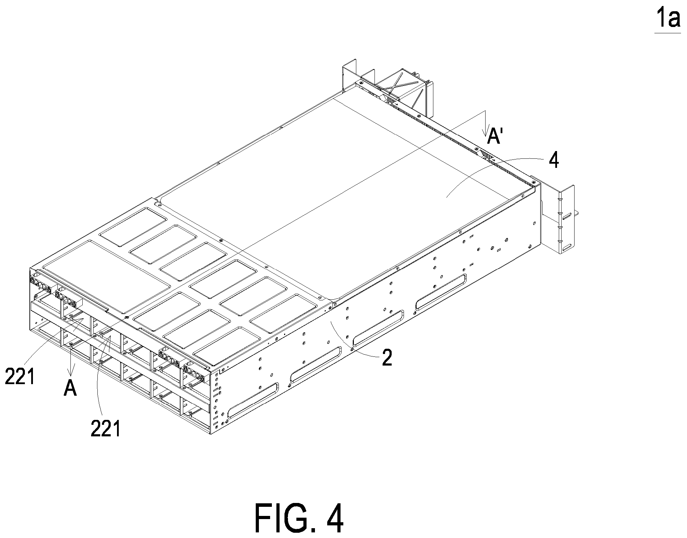

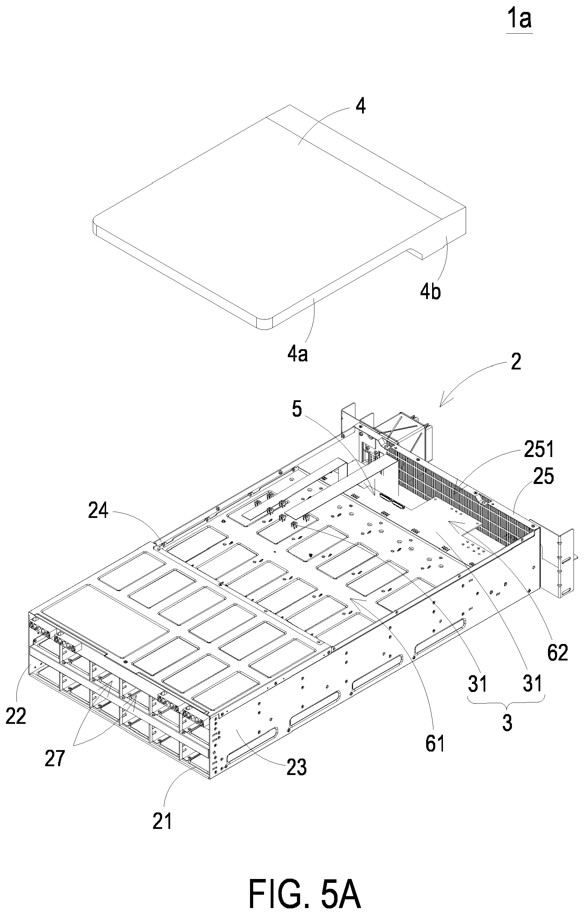

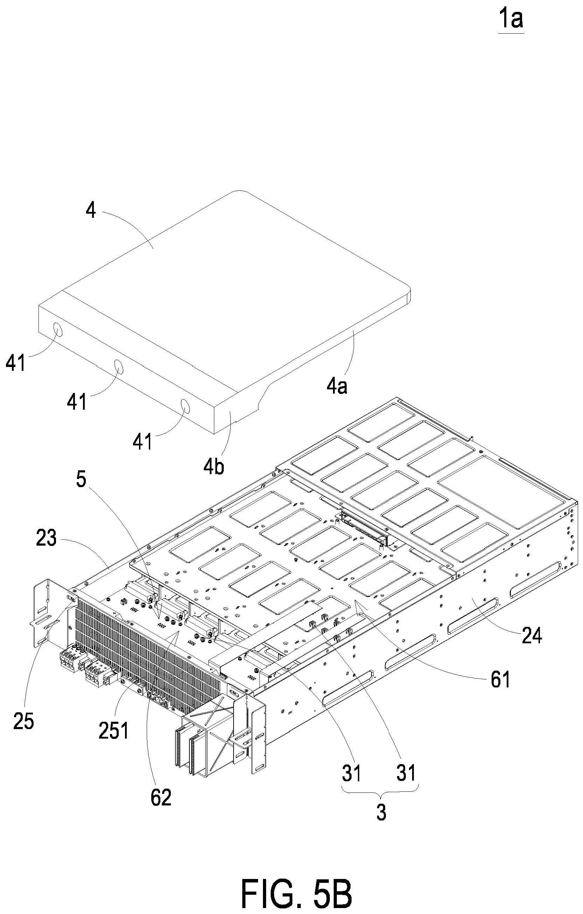

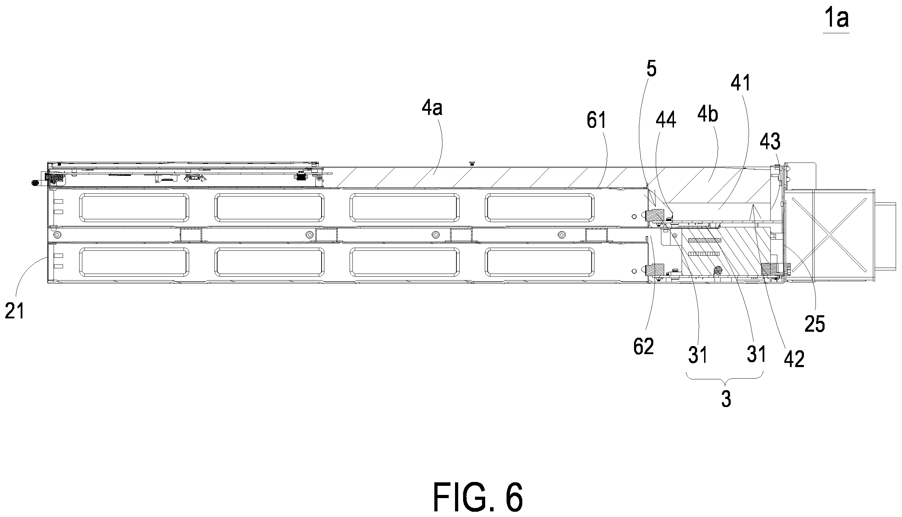

FIG. 4 is a schematic view illustrating an electronic device according to a second embodiment of the present disclosure. FIG. 5A is a schematic exploded view illustrating the electronic device as shown in FIG. 4. FIG. 5B is a schematic exploded view illustrating the electronic device as shown in FIG. 4 taken along another viewpoint. FIG. 6 is a schematic cross-sectional view illustrating the electronic device as shown in FIG. 4 taken along the line A-A'. As shown in FIGS. 4 to 6, compared with the electronic device 1 of the first embodiment, the carrier portion 2 of the electronic device 1a of this embodiment includes a rear side wall 25. The rear side wall 25 and the front side wall 22 are opposite to each other and disposed between the first side wall 23 and the second side wall 24. The rear side wall 25 includes a plurality of second through holes 251. Each second through hole 251 runs through the rear side wall 25. The cooling liquid passes through the second through hole 251 of the rear side wall 25 of the carrier portion 2 of the electronic device 1a. In this embodiment, the front side wall 22, the first side wall 23, the rear side wall 25 and the second side wall 24 are disposed around and connected with the carrier main body 21 so as to form an internal space. The cooling liquid passes through the internal space formed by the front side wall 22, the first side wall 23, the rear side wall 25, the second side wall 24 and the carrier main body 21 of the carrier portion 2.

In an embodiment of the electronic device 1a, the internal space of the electronic device 1a includes a first separated space 61 and a second separated space 62. The first separated space 61 and the second separated space 62 are two spaces isolated from the carrier portion 2 of the electronic device 1a. For example, the first separated space 61 and the second separated space 62 are the upper space and the lower space of the electronic device 1a, respectively. The filling component 4 of the electronic device 1a includes a first filling part 4a. At least a portion of the first filling part 4a is disposed in the first separated space 61. The first filling part 4a is a sealed structure for limiting or avoiding the cooling liquid from immersing to the first separated space 61. In an embodiment, the filling component 4 includes a second filling part 4b. At least a portion of the second filling part 4b is disposed in the second separated space 62. The thermal source region 5 of this embodiment is disposed in the second separated space 62. The liquid channel 41 is disposed in the second filling part 4b in communication with the thermal source region. Namely, at least a portion of the thermal source region 5 is contained within the liquid channel 41.

As shown in FIG. 6, a portion structure of the liquid channel 41 forms the thermal dissipation portion 42. At least a portion of the thermal dissipation portion 42 and the thermal source region 5 are spatially corresponding in position to each other. For example, at least a portion of the thermal dissipation portion 42 and the thermal source region 5 are spatially corresponding in position to each other. The first flow hole 43 and the second flow hole 44 are disposed on two opposite sides of the liquid channel 41, respectively. The cooling liquid passes through the liquid channel 41 through the first flow hole 43. The liquid channel 41 limits or guides the cooling liquid from passing through the thermal source region 5. The cooling liquid exchanges the thermal with the thermal source region 5. The cooling liquid flows out from the liquid channel 41 through the second flow hole 44.

The electronic device 1a of this embodiment is a power rack. A portion of the thermal source 31 of the electronic component 3 of the electronic device 1a has reduced thermal dissipation requirement. The thermal source 31 is away from the carrier main body 21 of the carrier portion 2 and disposed in the first separated space 61. The other portion of the thermal source 31 of the electronic component 3 of the electronic device 1a has enhanced thermal dissipation requirement. The thermal source 31 is adjacent to the carrier main body 21 of the carrier portion 2 and disposed in the second separated space 62 so as to dissipate the thermal through the cooling liquid passing through the second separated space 62. In this embodiment, at least a portion of the first flow hole 43 and/or the second flow hole 44 is communicated with the second through hole 251. The cooling liquid passes through the second through hole 251, the first flow hole 43 and the second flow hole 44, so that the thermal of the thermal source 31 is taken away from the thermal source region 5.

Moreover, in an embodiment of the electronic device 1a, the second filling part 4b is partially disposed in the second separated space 62 of the electronic device 1a. Namely, a portion of the second filling part 4b is not disposed in the second separated space 62. Consequently, the cooling liquid passes through the space of the second separated space 62 unoccupied by the second filling part 4b. The cooling liquid required by the second separated space 62 of the electronic device 1a is provided.

In an embodiment of the electronic device 1a, the first separated space 61 and the second separated space 62 of the electronic device 1a are not limited to the upper space and the lower space separated by the partition of the carrier portion 2. In some embodiments, the first separated space 61 and the second separated space 62 can be the left side and the right side of the electronic device 1a separated by the partition of the carrier portion 2, respectively. Alternatively, the first separated space 61 and the second separated space 62 can be any two spaces separated by the partition of the carrier portion 2, respectively.

Please refer to FIGS. 4, 5A and 5B again. The carrier portion 2 of the electronic device 1a further includes a plurality of third accommodation spaces 27. The plurality of third accommodation space 27 are disposed in the front side wall 22 of the carrier portion 2 for receiving the power unit (not shown) or the data storage device (not shown) of the power rack. The data storage device can be hard disk drive or random-access memory. When the power unit or the data storage device is omitted on the electronic device 1a based on the standard of the electronic device 1a, at least one of the plurality of third accommodation spaces 27 includes an accommodation filling component (not shown). The accommodation filling component limits or avoids the cooling liquid from passing through the corresponding third accommodation space 27. Consequently, the volume of the cooling liquid in the third accommodation space 27 is reduced.

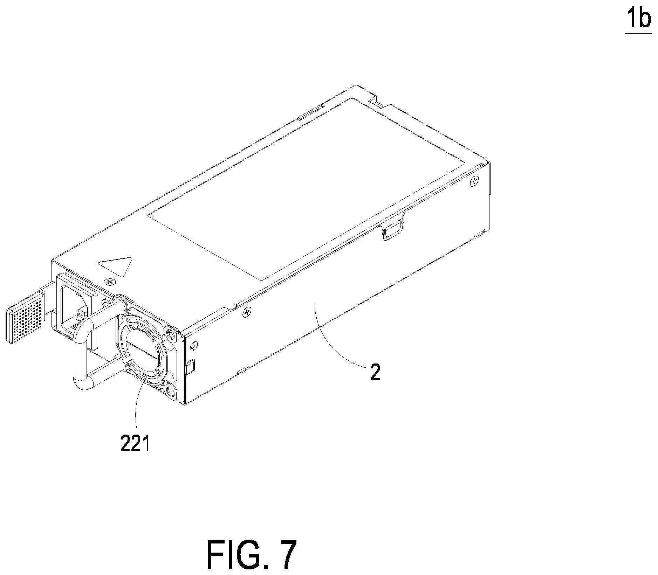

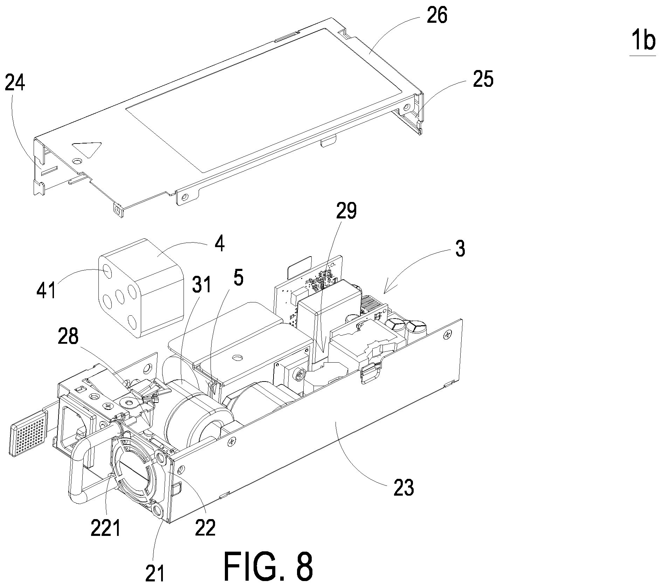

FIG. 7 is a schematic view illustrating an electronic device according to a third embodiment of the present disclosure. FIG. 8 is a schematic exploded view illustrating the electronic device as shown in FIG. 7. As shown in FIGS. 7 and 8, the electronic device 1b of this embodiment is an industrial electronic device. For example, the electronic device 1b is CRPS/MCRPS power supply, industrial power supply, server power supply, server, or networking device. The carrier portion 2 of the electronic device 1b further includes a third side wall 26. The third side wall 26 and the carrier main body 21 are opposite to each other, disposed between the first side wall 23 and the second side wall 24, and disposed between the front side wall 22 and the rear side wall 25. The electronic component 3 and the filling component 4 are disposed on the carrier portion 2. The electronic component 3 and the filling component 4 are disposed between the third side wall 26 and the carrier main body 21, disposed between the front side wall 22 and the rear side wall 25, and disposed between the first side wall 23 and the second side wall 24. The electronic component 3 includes a thermal source 31. The thermal source region 5 is disposed in the carrier portion 2 adjacent to the thermal source 31. In this embodiment, the second side wall 24, the third side wall 26 and the rear side wall 25 of the carrier portion 2 are integrally formed into one piece. The first side wall 23, the front side wall 22 and the carrier main body 21 are integrally formed into one piece.

In this embodiment, the carrier portion 2 further includes a first accommodation space 28 and a second accommodation space 29. The first accommodation space 28 and the second accommodation space 29 are defined by the first side wall 23, the third side wall 26, the front side wall 22, the carrier main body 21 and a portion of the electronic component 3 collaboratively. The first accommodation space 28 and a second accommodation space 29 are two spaces within the carrier portion 2. The first accommodation space 28 is adjacent to the front side wall 2. The filling component 4 fills in the first accommodation space 28 for limiting or avoiding the cooling liquid from immersing to the first accommodation space 28. The second accommodation space 29 is adjacent to the rear side wall 25. At least a portion of the thermal source 31 of the electronic component 3 is disposed within the second accommodation space 29. Namely, the thermal source region 5 is disposed in the second accommodation space 29. The filling component 4 limits or guides the cooling liquid from passing through the thermal source region 5. The cooling liquid exchanges the thermal with the thermal source region 5. In an embodiment, the first accommodation space 28 and the second accommodation space 29 are dispose in two sides of the carrier portion 2. The first accommodation space 28 and the second accommodation space 29 receive the corresponding electrical module, respectively. The electrical module is hot-plugged into the first accommodation space 28 and the second accommodation space 29 from the exterior of the electronic device 1b through the two sides of the carrier portion 2.

As mentioned above, the electronic device of the present disclosure includes a filling component. The filling component covers the electronic component and the carrier portion, or disposed between the electronic components of the electronic device, or disposed between the electronic component and the mechanical component, or disposed in the space between the mechanical components. Consequently, when the electronic device is disposed in the cooling slot, the filling component fills in the space within the electronic device. The volume and the cost of the cooling liquid are reduced. Moreover, the filling component of the electronic device of the present disclosure includes a liquid channel. The flow direction or the flow speed of the cooling liquid are limited through the liquid channel. The convection capability of the cooling liquid passing through the liquid channel is enhanced. Consequently, the dissipation capability of the cooling liquid for the thermal source region is enhanced. Moreover, the filling portion of the electronic device of the present disclosure includes a first filling part and a second filling part disposed in the first separated space and the second separated space for limiting or avoiding the cooling liquid from immersing to the first separated space and the second separated space. The second filling part further includes a liquid channel for guiding the cooling liquid to flow to the second separated space. Consequently, the cooling liquid required by the second separated space for exchanging the thermal is provided.

## Claims

1. An electronic device disposed in a cooling liquid of a cooling slot, and comprising:
a carrier portion;
an electronic component disposed on the carrier portion and comprising a thermal source;
a thermal source region disposed in the carrier portion and corresponding in position to the thermal source; and
a filling component disposed on the electronic component and comprising at least one liquid channel, wherein the at least one liquid channel runs through the filling component, the at least one liquid channel is communicated with the thermal source region for limiting or guiding the cooling liquid from passing through the thermal source region, and the cooling liquid is configured to exchange a thermal with the thermal source region.

2. The electronic device according to claim 1, wherein the thermal source region is disposed in corresponding one of the at least one liquid channel, the filling component comprises a thermal dissipation portion, a first flow hole and a second flow hole, the thermal dissipation portion is formed by a portion structure of the liquid channel, the thermal dissipation portion and the thermal source region are spatially corresponding is position to each other, and the first flow hole and the second flow hole are disposed in two sides of the liquid channel, so that the cooling liquid passes through the first flow hole and the second flow hole.

3. The electronic device according to claim 2, wherein the electronic component is disposed between the carrier portion and the filling component, and the electronic component is covered by the carrier portion and the filling component.

4. The electronic device according to claim 1, wherein the carrier portion comprises a carrier main body and a plurality of side walls, the plurality of side walls are disposed around and connected with the carrier main body so as to form an internal space, the cooling liquid passes through the internal space formed by the carrier main body and the plurality of side walls, and the cooling liquid is limited or guided from passing through the thermal source region through the liquid channel.

5. The electronic device according to claim 4, wherein the electronic device comprises a first separated space isolated from the carrier portion, the filling component comprises a first filling part, at least a portion of the first filling part is disposed in the first separated space, the first filling part is a sealed structure for limiting or avoiding the cooling liquid from immersing to the first separated space.

6. The electronic device according to claim 5, wherein the electronic device comprises a second separated space, the first separated space and the second separated space are two spaces isolated from the carrier potion, the filling component comprises a second filling part, at least a portion of the second filling part is disposed in the second separated space, the thermal source region is disposed in the second separated space, and the liquid channel is disposed in the second filling part.

7. The electronic device according to claim 6, wherein the liquid channel is communicated with the thermal source region, the filling component comprises a thermal dissipation portion, a first flow hole and a second flow hole, the thermal dissipation portion is formed by a portion structure of the liquid channel, the thermal dissipation portion and the thermal source region are spatially corresponding in position to each other, and the first flow hole and the second flow hole are disposed in two sides of the liquid channel, so that the cooling liquid passes through the first flow hole and the second flow hole.

8. The electronic device according to claim 4, wherein the filling component comprises a first flow hole and a second flow hole, the first flow hole and the second flow hole are disposed in two sides of the liquid channel, so that the cooling liquid passes through the first flow hole and the second flow hole, wherein the plurality of side walls comprises a through hole communicated with at least a portion of the first flow hole and/or the second flow hole, and the cooling liquid passes through the through hole, the first flow hole and the second flow hole, so that the thermal of the thermal source is taken away from the thermal source region.

9. The electronic device according to claim 1, wherein the filling component is waterproof foam, plastic structure, metal structure or any structure adapting to the cooling liquid.

10. The electronic device according to claim 1, wherein the electronic device is CRPS/MCRPS power supply, industrial power supply, server power supply, server, or networking device.

11. The electronic device according to claim 1, wherein the electronic component comprises a thermal source disposed in the thermal source region, wherein the thermal source is central processing unit, dual in-line memory module, PCIe card, graphics processing unit, electronic circuit, busbar, thermal sink, any thermal generating electronic component or thermal conductive structure.

12. An electronic device disposed in a cooling liquid of a cooling slot, and comprising:
a carrier portion comprising a first accommodation space, wherein the first accommodation space is formed within the carrier portion;
an electronic component disposed on the carrier portion and comprising a thermal source;
a thermal source region disposed in the carrier portion and corresponding in position to the thermal source; and
a filling component, wherein the filling component is a sealed structure and fills in the first accommodation space for limiting or avoiding the cooling liquid from immersing into the first accommodation space, wherein the filling component is configured to limit or guide the cooling liquid from passing through the thermal source region, and the cooling liquid is configured to exchange a thermal with the thermal source region.

13. The electronic device according to claim 12, wherein the carrier portion further comprises a second accommodation space, the second accommodation space and the first accommodation space are two spaces of the carrier potion, and the thermal source region is disposed in the second accommodation space.

14. The electronic device according to claim 13, wherein the first accommodation space and the second accommodation space are disposed in two sides of the carrier portion, the first accommodation space and the second accommodation space receive an electrical module, respectively, wherein the electrical module is hot-plugged into the first accommodation space and the second accommodation space from the exterior of the electronic device through the two sides of the carrier portion.

15. The electronic device according to claim 12, wherein the filling component is waterproof foam, plastic structure, metal structure or any structure adapting to the cooling liquid.

16. The electronic device according to claim 12, wherein the electronic device is CRPS/MCRPS power supply, industrial power supply, server power supply, server, or networking device.

17. The electronic device according to claim 12, wherein the electronic component comprises a thermal source disposed in the thermal source region, wherein the thermal source is central processing unit, dual in-line memory module, PCIe card, graphics processing unit, electronic circuit, busbar, thermal sink, any thermal generating electronic component or thermal conductive structure.

18. An electronic device disposed in a cooling liquid of a cooling slot, and comprising:
a carrier portion comprising a plurality of side walls and a carrier main body, wherein the plurality of side walls are disposed around the carrier main body to form a first accommodation space and a second accommodation space;
an electronic component comprising a thermal source disposed in the second accommodation space of the carrier portion;
a thermal source region disposed in the carrier portion and corresponding in position to the thermal source; and
a filling component disposed in the first accommodation space for limiting or avoiding the cooling liquid from immersing into the first accommodation space, wherein the filling component is configured to limit or guide the cooling liquid from passing through the thermal source region, and the cooling liquid is configured to exchange a thermal with the thermal source region.

19. The electronic device according to claim 18, wherein the plurality of side walls comprises a front side wall, the front side wall comprises a through hole running through the front side wall, the filling component comprises at least one liquid channel, wherein the at least one liquid channel is at least partially communicated with the through hole.

20. The electronic device according to claim 18, wherein the electronic device is CRPS/MCRPS power supply, industrial power supply, server power supply, server, or networking device.
